# EUROPÄISCHE PATENTSCHRIFT

(11) **EP 1 657 554 B1**
(45) Veröffentlichungstag und Bekanntmachung des Hinweises auf die Patenterteilung: **25.06.2008**
(21) Anmeldenummer: 05017273.3
(22) Anmeldetag: 09.08.2005
(51) Int. Cl.: G01R 11/04

(54) **Elektronischer Elektrizitätszähler**
Electronic electricity meter
Compteur d'électricité éléctrique

(30) Priorität: 05.11.2004 DE 202004017069 U
(43) Veröffentlichungstag der Anmeldung: 17.05.2006
(73) Patentinhaber: EMH Elektrizitätszähler GmbH & Co KG, 19243 Wittenburg (DE)
(72) Erfinder: Glomski, Mark, 21035 Hamburg (DE)
(74) Vertreter: Hauck Patent- und Rechtsanwälte

(56) Entgegenhaltungen:
- EP-A- 0 491 270
- EP-A- 0 913 696
- CH-A5- 683 660
- DE-A1- 4 111 263
- GB-A- 2 356 461

## Beschreibung

Die Erfindung bezieht sich auf einen elektronischen Elektrizitätszähler nach dem Anspruch 1.

Herkömmliche Elektrizitätszähler weisen den Nachteil auf, daß die Stromzufuhr zum Versorger unterbrochen ist, wenn der Zähler repariert oder ausgetauscht wird. Es ist daher auch bereits bekannt, einen derartigen Zähler zweiteilig auszubilden in der Weise, daß eine Plattform, die mit Anschlußmöglichkeiten für die Versorgungsleitungen versehen ist, ständig am Anbringungsort verbleibt, während ein Gehäuse, das alle Bauteile und Komponenten eines elektronischen Elektrizitätszählers enthält, lösbar mit der Plattform verbindbar ist. Die Verbindung geschieht z.B. mit Hilfe von zapfenartigen Vorsprüngen des Gehäuses, welche in entsprechende Ausnehmungen der Plattform eingreifen. Es findet dabei vorzugsweise eine Verhakung zwischen den Teilen statt, und ein Plombierelement, das sich durch das Gehäuse bis zur Plattform hin erstreckt, verriegelt das Gehäuse an der Plattform. Die Verriegelung kann nur aufgehoben werden, wenn das Plombierelement gelöst wird, was wiederum nur durch Beschädigung der Plombe geschehen kann. Diese Anordnung hat den Vorteil, daß bei Lösen des Gehäuses von der Zählerplattform die Verbindung zum Versorger nicht unterbrochen ist und keine gefährlichen Arbeiten unter Spannung durchgeführt werden müssen. Ein Zähleraustausch läßt sich innerhalb kürzester Zeit bewerkstelligen, so daß für den Energieversorger Verluste nicht entstehen. Die Zählerplattform ist entweder für sich z.B. an einer Wand eines Gebäudes angebracht oder befindet sich innerhalb eines Zählerschranks oder ist Teil einer Wand des Zählerschranks.

EP-A-0 913 696 beschreibt einen elektronischen Elektrizitätszähler mit einer Zählerplatform, die Anschlüsse für die einzelnen Phasen der elektrischen Versorgungsleiter aufweist. D1 bildet ein Gehäuse, indem eine Haube auf die Zählerplatform aufgebracht wird.

GB-A-2 356 461 offenbart ein Gehäuse mit Unterseite und Haube. Die Unterseite wird unmittelbar auf einer Wand oder Platte aufgebracht.

CH-A-683660 beschreibt ein Gehäuse, die eine Haube und eine Unterseite aufweist. Die Haube hat vier Beinen mit Ausnehmungen, welche mit Vorsprünge an der Innenseite der Gehäusewand zusammenwirken. Das Dokument beschreibt separate Plombierelemente, die die Verriegelung zwischen dem Unterteil und der Haube des Gehäuses sicherstellen.

DE-A-41 11 263 und EP-A-0 491 270 offenbaren Plombiervorrichtungen für allgemeine elektronischen Geräten, um Verschmutzung und unbefügte Berührung zu vermeiden. Außerdem erfolgt die Verriegelungsfunktion über Plombierelemente.

Der Erfindung liegt die Aufgabe zugrunde, einen elektronischen Elektrizitätszähler mit einem Gehäuse für die Aufnahme der Bauteile und Komponenten so auszubilden, daß das Gehäuse auf einfache Weise aus Kunststoffmaterial gefertigt werden und eine Verbindung der Gehäuseteile durch einfaches Aufeinanderstecken erfolgen kann bei gleichzeitiger unlösbarer Verriegelung der Teile nach dem Zusammenstecken.

Diese Aufgabe wird durch die Merkmale des Anspruchs 1 gelöst.

Bei der Erfindung weist das Gehäuse ein kastenförmiges Unterteil von rechteckigem Querschnitt oder Grundriß auf, das auf die Plattform aufsteckbar ausgebildet ist, vorzugsweise mit der Bodenseite, wobei an der Unterseite des Bodens entsprechende Steckzapfen vorgesehen sein können. Auf die obere oder offene Seite des Unterteils wird ein kastenförmiges Haubenteil aufgesetzt, das vier Beine aufweist, vorzugsweise in den Eckbereichen. Die Beine weisen Verriegelungsausnehmungen oder -öffnungen auf, die mit Verriegelungsvorsprüngen an der Innenseite der Gehäusewände zusammenwirken. Nach dem Aufstecken der Haube und dem Eingriff der Verriegelungsvorsprünge in die Verriegelungsausnehmungen oder -öffnungen kann die Haube nicht mehr vom Oberteil abgezogen werden. Erfindungsgemäß sind ferner Verriegelungsflächen an der Innenseite der Seitenwände vorgesehen, die ein Auslenken der Beine von den Verriegelungsvorsprüngen fort verhindern. Dadurch ist sichergestellt, daß auch beim Versuch, die Haube durch Drehen und Ankippen vom Unterteil zu entfernen, ein Außereingriffbringen von Verrieglungsvorsprüngen und Verriegelungsausnehmungen bzw. -öffnungen ausgeschlossen ist. Die Haube und das Unterteil weisen schließlich zusammenwirkende Mittel auf, die eine seitliche Relativbewegung zwischen den Teilen verhindern. Ist die Haube einmal vollständig auf das Unterteil aufgesteckt, kann die Haube nur durch ihre Zerstörung vom Unterteil entfernt werden.

Haube und Unterteil werden vorzugsweise aus geeignetem Kunststoffmaterial einteilig geformt, wobei das Unterteil vorzugsweise aus opaquem Kunststoff besteht, während die Haube zumindest teilweise durchsichtig bzw. durchscheinend ist.

Das Unterteil ist so bemessen und ausgebildet, gegebenenfalls mit entsprechenden Vorkehrungen ausgestattet, daß alle für einen elektronischen Elektrizitätszähler vorhandenen Bauteile und Komponenten aufgenommen werden können. Dazu gehören insbesondere eine Leiterplatte, gegebenenfalls mit Display, Stromwandler und stromführende Leiterabschnitte, welche den Strom durch die Stromwandler hindurchführen. Die Herstellung der Gehäuseteile ist denkbar einfach. Auch das Zusammenbringen der Gehäuseteile kann mit einem Handgriff erfolgen, ohne daß umständliche Verschraubungen oder sonstige Verbindungsmaßnahmen erforderlich sind. Nach dem vollständigen Aufsetzen der Haube auf das Gehäuseunterteil kann eine Entfernung der Haube nicht mehr vollzogen werden.

Nach einer Ausgestaltung der Erfindung verläuft eine Außenfläche der Beine annähernd senkrecht zur Verriegelungsöffnung und annähernd parallel zur zugeordneten Innenwand nahe an dieser. Dadurch ist eine weitere Sicherung für die Beine gegeben. Vorzugsweise liegen jeweils zwei Verriegelungsbeine, die in einer Richtung flach ausgeführt werden können, in einer Ebene, und zwar vorzugsweise in den Eckbereichen der rechteckigen Haube.

Nach einer weiteren Ausgestaltung der Erfindung ist oberhalb der Verriegelungsvorsprünge eine Rampenfläche vorgesehen, an der entlang die freien Enden der Beine zunächst laufen, bevor die Vorsprünge in die Verriegelungsausnehmung oder -öffnung einschnappen. Oberhalb der Verriegelungsflächen ist eine zweite Rampenfläche vorgesehen, die die Beine beim Einführen in das Unterteil in Richtung Verriegelungsvorsprung lenkt. Diese konstruktiven Maßnahmen sichern ein Einschnappen der Verriegelungsvorsprünge in die Verriegelungsausnehmungen bzw. -öffnungen beim Aufsetzen der Haube auf das Unterteil, und der Monteur kann das Einschnappen akustisch feststellen, da die Beine zunächst in sich verformt werden, bevor das Einschnappen stattfindet. Die Verformung führt zu einer Verspannung der Beine, die erst nach dem Einschnappen der Verriegelungsvorsprünge aufgehoben ist. Ein Lösen der Beine müßte diese Verformung realisieren, was ohne Hilfsmittel nicht möglich ist, insbesondere nicht durch ein Manipulieren an der Haube.

Nach einer anderen Ausgestaltung der Erfindung weist die Haube einen schürzenartigen äußeren Rand und einen schürzenartigen inneren Rand auf, wobei die schürzenartigen Ränder einen schmalen Zwischenraum bilden, in dem Stege an der freien Kante des Unterteils eingreifen. Dadurch ist eine Relativbewegung von Haube und Unterteil in der Trennebene begrenzt oder komplett verhindert.

Nach einer weiteren Ausgestaltung der Erfindung ist an der Innenseite des Deckenabschnitts der Haube ein hülsenförmiger Ansatz angeformt, der mit einer Öffnung oder einem weiteren hülsenförmigen Ansatz am Boden des Unterteils ausgerichtet ist zur Aufnahme eines Plombierstiftes.

Die Erfindung wird nachfolgend anhand eines in Zeichnungen dargestellten Ausführungsbeispiels näher erläutert.
- Fig. 1: zeigt perspektivisch ein kastenförmiges Unterteil nach der Erfindung von der offenen Seite.
- Fig. 2: zeigt perspektivisch eine kappenartige Haube für das Unterteil nach Fig. 1 von der Oberseite.
- Fig. 3: zeigt perspektivisch das Unterteil nach Fig. 1 von der Unterseite.
- Fig. 4: zeigt perspektivisch die Haube nach Fig. 2 von der Unterseite.

- Fig. 5: zeigt perspektivisch das Unterteil nach Fign. 1 und 3 von der Oberseite unter Weglassung von zwei Seitenwänden.
- Fig. 6: zeigt einen Schnitt durch ein kastenförmiges Gehäuse nach dem Zusammenfügen des Unterteils und der Haube.

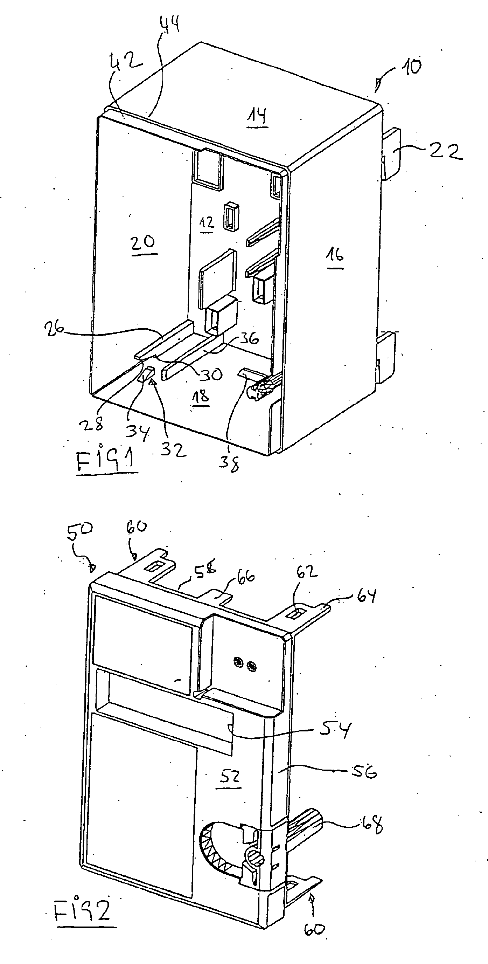

In den Fign. 1, 3 und 6 ist ein rechteckförmiges, kastenförmiges Unterteil 10 zu erkennen, das einen Boden 12 und vier Seitenwände 14, 16, 18 und 20 aufweist. An der Unterseite des Bodens 12 sind jeweils an den Längsseiten vier hakenartige Vorsprünge 22 geformt. Die Vorsprünge dienen zum Einsetzen in entsprechende Schlitze einer nicht gezeigten Zählerplattform, wie sie grundsätzlich an sich bekannt ist. Die Zählerplattform wird an einer Zählerplatte in einem Gebäudes angebracht und weist Anschlußmittel auf für die Phasen der Versorgungsleitungen. Im Boden 12 sind ferner mehrere rechteckige Schlitze 24 eingeformt. Sie dienen zur Durchführung von Verbindungsleiterstücken zwischen der nicht gezeigten Zählerplattform und einer Leiterplatte (nicht gezeigt) im Innern des kastenförmigen Unterteils 10. Die Leiterplatte enthält die bekannten Teile und Komponenten für einen elektronischen Elektrizitätszähler, u.a. auch Stromwandler, durch welche sich die Leiterstücke erstrecken, um die zum Versorger hin fließende Leistung zu messen. Wie aus Fig. 1 hervorgeht, sind am Boden 12 des Unterteils 10 an der Innenseite mehrere verschiedene Vorsprünge ausgebildet, die zum Teil mit den Schlitzen 24 ausgerichtet sind. Sie dienen der Montage der nicht gezeigten Leiterplatte sowie der besseren Hindurchführung der nicht gezeigten Leiterstücke. Hierauf soll weiter nicht eingegangen werden.

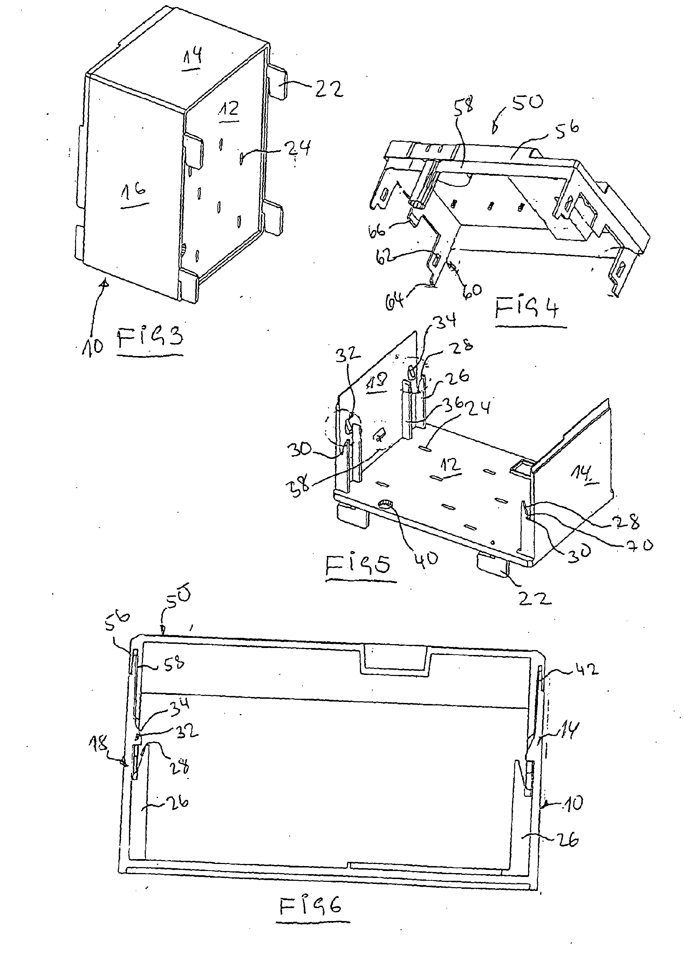

An der Innenseite der Seitenwände 14 bis 20 sind an den Ecken Leisten 26 geformt. An den freien Enden weisen die Leisten 26 Rampenflächen 28 auf, die zu den zugeordneten Innenwänden hin gerichtet sind, wobei das Gefälle derart ist, daß die Rampenflächen 28 sich nacheinander der jeweiligen Innenwand nähern. Am Ende der Rampenflächen 28 ist eine Schulter 30 geformt (siehe auch Fig. 5; wie erkennbar fehlen in Fig. 5 die am Boden 12 angeformten Teile gemäß Fig. 1). Auf der Innenseite der Seitenwände 14, 18 sind Verriegelungsvorsprünge 32 vorgesehen, die zur offenen Seite des Unterteils 10 hin ebenfalls eine Rampenfläche 34 aufweisen. Die Verriegelungsvorsprünge 32 liegen zwischen den Leisten 26 und parallelen Rippen 36, die an den Seitenwänden 14, 18 geformt sind.

An der Innenseite der Seitenwände 14, 18 sind weitere Vorsprünge 38 geformt. Sie dienen zur Festlegung der nicht gezeigten Leiterplatte im Innern des Unterteils 10, worauf, wie erwähnt, nicht näher eingegangen werden soll.

Schließlich weist der Boden 12 eine kreisrunde Öffnung 40 auf.

Wie aus den Fign. 1 und 3 zu erkennen, weist die freie Kante der Seitenwände 14 bis 20 einen nahezu vollständig umlaufenden Steg 42 auf. Seine Innenseite geht über in die Innenfläche der Seitenwände 14 bis 20, während die Außenseite gegenüber den Außenflächen der Seitenwände 14 bis 20 versetzt ist, so daß eine umlaufende Stufe 44 gebildet ist.

In den Fign. 2, 4 und 6 ist eine kappenförmige Haube 50 zu erkennen. Während das Unterteil 10 vorzugsweise aus einem opaquen Kunststoff geformt ist, ist die Haube 50 vorzugsweise aus einem durchsichtigen bzw. durchscheinenden Kunststoff gefertigt, z.B. aus Polycarbonat. Die Haube 50 weist einen Deckenabschnitt 52 auf, der mit Einprägungen versehen ist, auf die weiter nicht eingegangen werden soll. Die Einprägung 54 dient z.B. zum Betrachten eines Displays der Leiterplatte im Innern des kastenförmigen Teils 10 (nicht gezeigt). Die Haube 50 weist einen äußeren Rand 56 auf, der in unterschiedlicher Höhe umläuft. Im Abstand zum äußeren Rand 56 ist ein innerer Rand 58 geformt, wobei der innere Rand 58 deutlich breiter ist als der äußere Rand 56. Zwischen diesen beiden ist ein Zwischenraum gebildet, der den Steg 42 des Unterteils 10 aufnimmt, wie in Fig. 6 zu erkennen. Der innere Rand 58 legt sich gegen die zugeordnete Innenseite der Seitenwände 14 bis 20 an, wenn die Haube 50 vollständig auf das Unterteil 10 aufgesetzt ist (Fig. 6).

In Verlängerung des inneren Randes 58 sind in den Eckbereichen der Haube 50 Beine 60 geformt. Die Beine 60 haben die gleiche Dicke wie der innere Rand 58, und die flachen Seiten der Beine 60 fluchten mit den zugekehrten Seiten des inneren Randes 58 (siehe Fign. 4 und 6). Somit liegen die Verriegelungsbeine 60 jeweils paarweise in einer Ebene mit dem Rand, an den sie angeformt sind. Jedes Verriegelungsbein 60 weist eine rechteckige Verriegelungsöffnung 62 auf. Versetzt zur Verriegelungsöffnung 62 ist ein Ansatz 64 an jedem Bein 60 geformt.

Zwischen den Beinen 60 in deren gemeinsamer Ebene ist ein Ansatz 66 am inneren Rand 58 geformt.

Am Deckenabschnitt 52 der Haube 50 ist ein hülsenförmiger Ansatz 68 geformt, der mit der Öffnung 40 (Fig. 5) des Bodens 12 ausgerichtet ist, wenn die Haube 50 auf das Unterteil 10 aufgesetzt ist.

Wird die Haube 50 auf das Unterteil 10 aufgesetzt, gleiten die Verriegelungsbeine 60 an der Innenseite der Seitenwände 14, 18. Der Abschnitt der Beine 60, in dem sich die Verriegelungsöffnung 62 befindet, gleitet über die Rampenfläche 34, wodurch das Bein 60, das flexibel ist, ausgelenkt wird. Gleichzeitig wird der Ansatz 64 durch die Rampenfläche 28 in Richtung Seitenwand verformt. Dadurch entsteht eine erhebliche Spannung im Verriegelungsbein 60, die erst beseitigt ist, wenn der Verriegelungsvorsprung 32 in die Verriegelungsöffnung 62 einschnappt. Die Rampenfläche 28 der Leisten 26 endet in einer Verriegelungsfläche 70, welche verhindert, daß das Verriegelungsbein 60 vom Verriegelungsvorsprung 32 fort gebogen werden kann. Durch die beschriebene Verriegelung ist es ohne Zerstörung bestimmter Teile von Unterteil 10 und/oder Haube 50 nicht möglich, die Haube 50 vom Unterteil 10 zu lösen. Die Verriegelungsbeine 60 liegen nahezu an der zugekehrten Innenseite der Seitenwände 14, 18 an und verhindern zusammen mit dem Steg 42 und den beabstandeten Rändern 56, 58, daß die Haube 50 relativ zum Unterteil 10 in der Trennebene bewegt werden kann, um eine Entriegelung der Haube zu bewirken. Durch den hülsenförmigen Ansatz 68 und die Öffnung 40 im Unterteil 10 kann ein nicht gezeigter Plombierstift gesteckt werden, mit welchem das in Fig. 6 gezeigte verschlossene Gehäuse an der nicht gezeigten Zählerplattform verriegelt werden kann. Durch Zerstören der Plombe kann ein derartiger Plombierstift betätigt werden, um die Verriegelung zu lösen und somit das in Fig. 6 gezeigte vollständige Gehäuse von der Trägerplattform zu entfernen. Es sei angemerkt, daß in Fig. 6 die hakenförmigen Abschnitte 22 nicht eingezeichnet sind.

## Patentansprüche

1. Elektronischer Elektrizitätszähler mit einem Gehäuse zur Aufnahme von Bauteilen und Komponenten des Elektrizitätszählers, das auf einer Zählerplattform lösbar aufsteckbar ausgebildet ist, die Anschlüsse für die einzelnen Phasen der elektrischen Versorgungsleitungen sowie Kontakte aufweist, die mit Kontakten des Elektrizitätszählers im Gehäuse zusammenwirken, wenn das Gehäuse auf die Zähler Plattform aufgesteckt ist, wobei die Steckverbindung zwischen Gehäuse und Zähler Plattform durch ein längliches Plombierelement verriegelbar ist, das von der Vorderseite des Gehäuses durch dieses hindurch mit der Zählerplattform zusammenwirkt, **dadurch gekennzeichnet, daß** das Gehäuse ein kastenförmiges Unterteil (10) mit rechteckigem Grundriß aufweist, das auf die Zähler Plattform aufsteckbar ausgebildet ist, und eine auf die offene Seite des Unterteils (10) aufsetzbare Haube (50), die Haube (50) vier Beine (60) aufweist, die vorzugsweise in Eckbereichen angeordnet sind und bei Montage der Haube innerhalb des Unterteils (10) liegen, die Beine (60) Verriegelungsausnehmungen oder -öffnungen (62) aufweisen, die mit einem Verriegelungsvorsprung (32) an der Innenseite der Gehäusewand (14, 18) zusammenwirken, an der Innenseite der Gehäusewände (14, 18) Verriegelungsflächen (70) ausgebildet sind, die eine Auslenkung der Beine (60) von den Verriegelungsvorsprüngen (32) fort verhindern, wenn die Beine (60) in das Unterteil (10) eingeführt sind und Unterteil (10) und Haube (50) zusammenwirkende Mittel aufweisen, die eine seitliche Relativbewegung der Teile in deren Trennebene verhindern.

2. Elektrizitätszähler nach Anspruch 1, **dadurch gekennzeichnet, daß** eine Außenfläche der Beine (60) die annähernd senkrecht zur Achse der Verriegelungsöffnung (62) verläuft, annähernd parallel zur zugeordneten Innenwand nahe an liegt.

3. Elektrizitätszähler nach Anspruch 1 oder 2, **dadurch gekennzeichnet, daß** jeweils zwei Verriegelungsbeine (60) in einer gemeinsamen Ebene liegen.

4. Elektrizitätszähler nach einem der Ansprüche 1 bis 3, **dadurch gekennzeichnet, daß** oberhalb der Verriegelungsvorsprünge (32) eine Rampenfläche (34) vorgesehen ist, an der die freien Enden der Beine (60) zunächst entlang laufen, bevor die Verriegelungsvorsprünge (32) in die Verriegelungsausnehmung oder -öffnung (62) einschnappen und oberhalb der Verriegelungsfläche (70) eine zweite Rampenfläche (28) vorgesehen ist, die die Beine (60) beim Einführen in das Unterteil (10) in Richtung Verriegelungsvorsprung (32) lenken.

5. Elektrizitätszähler nach einem der Ansprüche 1 bis 4, **dadurch gekennzeichnet, daß** ein mit der Verriegelungsfläche (70) zusammenwirkender erster Abschnitt (64) der Beine (60) am freien Ende über einen zweiten Abschnitt, der die Verriegelungsausnehmung oder -öffnung (62) enthält, hinausragt.

6. Elektrizitätszähler nach einem der Ansprüche 1 bis 5, **dadurch gekennzeichnet, daß** die Haube (50) einen schürzenartigen äußeren Rand (56) und einen schürzenartigen inneren Rand (58) aufweist, wobei äußerer und innerer Rand einen schmalen Zwischenraum bilden und an den freien Kanten des Unterteils (10) ein Steg (42) geformt ist, der beim Aufsetzen der Haube (50) in den Zwischenraum eingreift.

7. Elektrizitätszähler nach Anspruch 6, **dadurch gekennzeichnet, daß** der innere Rand (58) breiter ist als der äußere Rand (56) und auf der Innenseite des Unterteils (10) zu liegen kommt, wenn die Haube (50) aufgesetzt ist, wobei der äußere Rand (56) auf einer Schulter (44) der freien Kanten aufsitzt.

8. Elektrizitätszähler nach einem der Ansprüche 2 bis 7, **dadurch gekennzeichnet, daß** die Beine (60) in Richtung Achse der Verriegelungsausnehmung oder -öffnung (62) dünn bzw. flexibel sind.

9. Elektrizitätszähler nach einem der Ansprüche 1 bis 8, **dadurch gekennzeichnet, daß** an der Innenseite des Deckenabschnitts (52) der Haube (50) ein hülsenförmiger Ansatz (68) geformt ist, der mit einer Öffnung (40) im Boden (12) des Unterteils (10) ausgerichtet ist zur Aufnahme eines Plombierstiftes.

## Claims

1. Electronic electricity meter comprising a housing for receiving parts and components of the electricity meter which is configured to be able to be positioned releasably on a meter platform, which comprises terminals for the individual phases of the electrical supply lines as well as contacts, which cooperate with contacts of the electricity meter in the housing when the housing is positioned on the meter platform, the plug connection between the housing and the meter platform being able to be locked by an elongate lead sealing element which cooperates with the meter platform from the front face of the housing, through said housing, **characterised in that** the housing has a box-shaped lower part (10) with a rectangular contour, which is configured to be able to be positioned on the meter platform, and a cover (50) which may be positioned on the open side of the lower part (10), the cover (50) comprising four legs (60) which are preferably arranged in corner regions, and when mounting the cover are located inside the lower part (10), the legs (60) comprising locking recesses or locking apertures (62), which cooperate with a locking projection (32) on the inner face of the housing wall (14, 18), locking faces (70) being configured on the inner face of the housing wall (14, 18) which prevent a deflection of the legs (60) away from the locking projections (32) when the legs (60) are inserted into the lower part (10), and the lower part (10) and the cover (50) comprising cooperating means which prevent a lateral relative movement of the parts in the separating plane thereof.

2. Electricity meter according to Claim 1, **characterised in that** an outer face of the legs (60) which extends approximately perpendicular to the axis of the locking aperture (62), is located approximately parallel to, and in the vicinity of, the associated internal wall.

3. Electricity meter according to Claim 1 or 2, **characterised in that** two respective locking legs (60) are located in a common plane.

4. Electricity meter according to one of Claims 1 to 3, **characterised in that** above the locking projections (32) a ramp face (34) is provided along which the free ends of the legs (60) initially extend, before the locking projections (32) snap into the locking recess or locking aperture (62) and above the locking face (70) a second ramp face (28) is provided which deflects the legs (60) in the direction of the locking projection (32) when inserted into the lower part (10).

5. Electricity meter according to one of Claims 1 to 4, **characterised in that** a first portion (64) of the legs (60) cooperating with the locking face (70) projects at the free end beyond a second portion which contains the locking recess or locking aperture (62).

6. Electricity meter according to one of Claims 1 to 5, **characterised in that** the cover (50) has a skirt-like outer edge (56) and a skirt-like inner edge (58), the outer and inner edges forming a narrow space and at the free edges of the lower part (10) a web (42) is formed which engages in the space when the cover (50) is positioned.

7. Electricity meter according to Claim 6, **characterised in that** the inner edge (58) is wider than the outer edge (56) and comes to rest on the inner face of the lower part (10) when the cover (50) is positioned, the outer edge (56) being positioned on a shoulder (44) of the free edges.

8. Electricity meter according to one of Claims 2 to 7, **characterised in that** the legs (60) are thin and/or flexible in the direction of the axis of the locking recess or locking aperture (62).

9. Electricity meter according to one of Claims 1 to 8, **characterised in that** on the inner face of the top portion (52) of the cover (50) a sleeve-shaped extension (68) is formed which is aligned with an aperture (40) in the base (12) of the lower part (10) for receiving a lead sealing pin.

## Revendications

1. Compteur d'électricité électrique avec un boîtier pour le logement d'éléments et composants du compteur d'électricité, qui est constitué de manière emboîtable sur une plateforme de compteur qui présente des branchements pour les différentes phases des lignes d'alimentation électriques ainsi que des contacts, qui coopèrent avec des contacts du compteur d'électricité dans le boîtier, quand le boîtier est emboîté sur la plateforme de compteur, l'assemblage par emboîtement entre le boîtier et la plateforme de compteur étant verrouillable par un élément de plombage oblong, qui coopère depuis la face avant du boîtier à travers ce dernier avec la plateforme de compteur, **caractérisé en ce que** le boîtier présente une partie inférieure (10) en forme de caisson avec un tracé rectangulaire, qui est constitué de manière emboîtable sur la plateforme de compteur, et un couvercle (50) pouvant être posé sur le côté ouvert de la partie inférieure (10), le couvercle (50) présente quatre branches (60), qui sont disposées de préférence dans les zones de coin et se trouvent lors du montage du couvercle à l'intérieur de la partie inférieure (10), les branches (60) présentent des évidements ou ouvertures de verrouillage (62), qui coopèrent avec une saillie de verrouillage (32) du côté interne de la paroi de boîtier (14, 18), des surfaces de verrouillage (70) sont constituées sur le côté interne des parois de boîtier (14, 18), qui empêchent une déviation des branches (60) depuis les saillies de verrouillage (32), quand les branches (60) sont introduites dans la partie inférieure (10) et la partie inférieure (10) et le couvercle (50) présentent des moyens coopérant, qui empêchent un mouvement relatif latéral des éléments dans leur plan de séparation.

2. Compteur d'électricité selon la revendication 1, **caractérisé en ce qu'**une surface externe des branches (60) qui s'étend approximativement perpendiculairement à l'axe de l'ouverture de verrouillage (62) avoisine de près la paroi interne correspondante de manière approximativement parallèle.

3. Compteur d'électricité selon la revendication 1 ou 2, **caractérisé en ce que** respectivement deux branches de verrouillage (60) se trouvent dans un plan commun.

4. Compteur d'électricité selon l'une des revendications 1 à 3, **caractérisé en ce qu'**une surface de rampe (34) est prévue au-dessus des saillies de verrouillage (32), le long de laquelle les extrémités libres des branches (60) passent d'abord, avant que les saillies de verrouillage (32) ne s'enclenchent dans l'évidement ou l'ouverture de verrouillage (62) et une seconde surface de rampe (28) est prévue au-dessus de la surface de verrouillage (70), qui dirige les branches (60) lors de l'introduction dans la partie inférieure (10) en direction de la saillie de verrouillage (32).

5. Compteur d'électricité selon l'une des revendications 1 à 4, **caractérisé en ce qu'**une première section (64) des branches (60) coopérant avec la surface de verrouillage (70) dépasse à l'extrémité libre au-dessus d'une seconde section qui contient l'évidemment ou l'ouverture de verrouillage (62).

6. Compteur d'électricité selon l'une des revendications 1 à 5, **caractérisé en ce que** le couvercle (50) présente un bord externe (56) de type tablier et un bord interne (58) de type tablier, les bords externe et interne formant un espace intermédiaire étroit et un listel (42) qui engrène dans l'espace intermédiaire lors de la pose du couvercle (50) étant formé aux arêtes libres de la partie inférieure (10).

7. Compteur d'électricité selon la revendication 6, **caractérisé en ce que** le bord interne (58) est plus large que le bord externe (56) et vient se poser sur le côté interne de la partie inférieure (10) quand le couvercle (50) est posé, le bord externe (56) reposant sur un épaulement (44) de l'arête libre.

8. Compteur d'électricité selon l'une des revendications 2 à 7, **caractérisé en ce que** les branches (60) sont minces et/ou flexibles dans la direction de l'axe de l'évidement ou l'ouverture de verrouillage (62).

9. Compteur d'électricité selon l'une des revendications 1 à 8, **caractérisé en ce que** sur le côté interne de la section de plafond (52) du couvercle (50), un appendice en forme de manchon (68) est formé qui est aligné avec une ouverture (40) dans le fond (12) de la partie inférieure (10) pour le logement d'une cheville de plombage.
